(19) **Europäisches Patentamt / European Patent Office / Office européen des brevets**

(11) **EP 3 406 014 B1**

(12) **FASCICULE DE BREVET EUROPEEN**

(45) Date de publication et mention de la délivrance du brevet:
**27.11.2019 Bulletin 2019/48**

(21) Numéro de dépôt: **17706544.8**

(22) Date de dépôt: **19.01.2017**

(51) Int Cl.:
*H02J 3/00* *(2006.01)*     *H02J 13/00* *(2006.01)*

(86) Numéro de dépôt international:
**PCT/FR2017/050109**

(87) Numéro de publication internationale:
**WO 2017/125683 (27.07.2017 Gazette 2017/30)**

(54) **SYSTÈME ET PROCÉDÉ DE DÉTERMINATION DYNAMIQUE DE CAPACITÉS MAXIMALES DE TRANSPORT DE COURANT ÉLECTRIQUE**

SYSTEM UND VERFAHREN ZUR DYNAMISCHEN BESTIMMUNG VON MAXIMALEN ELEKTRISCHEN STROMTRAGFÄHIGKEITEN

SYSTEM AND METHOD FOR DYNAMICALLY DETERMINING MAXIMUM ELECTRIC CURRENT CARRYING CAPACITIES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats de validation désignés:
**MA**

(30) Priorité: **21.01.2016 FR 1650466**

(43) Date de publication de la demande:
**28.11.2018 Bulletin 2018/48**

(73) Titulaire: **RTE Réseau de Transport d'Electricité 92073 La Défense Cedex (FR)**

(72) Inventeur: **BUHAGIAR, Thierry 13009 Marseille (FR)**

(74) Mandataire: **Bonnet, Michel Cabinet Bonnet 93, rue Réaumur 75002 Paris (FR)**

(56) Documents cités:
| | |
|---|---|
| WO-A1-2012/015507 | WO-A1-2016/102443 |
| US-A1- 2013 054 162 | US-A1- 2013 205 900 |
| US-A1- 2014 163 884 | US-A1- 2014 180 616 |

**Description**

La présente invention concerne un système de détermination dynamique de capacités maximales de transport de courant électrique relatives à une portion de réseau de transmission de courant électrique à haute tension. Elle concerne également un procédé correspondant ainsi qu'une installation de transmission électrique comportant un tel système.

Elle porte plus précisément sur un système comportant :

- des moyens de stockage d'un modèle de la portion de réseau, ce modèle comportant des points singuliers et au moins une ligne conductrice de courant électrique à haute tension entre ces points singuliers, d'une relation d'équilibre thermique prédéterminée, d'une température limite de fonctionnement de chaque ligne conductrice et de paramètres de conduction de chaque ligne conductrice,
- un calculateur, ayant accès aux moyens de stockage, programmé pour calculer au moins une valeur de capacité maximale en chaque point singulier du modèle de portion de réseau à partir de la relation d'équilibre thermique prédéterminée, de chaque température limite de fonctionnement, de chaque paramètre de conduction et de paramètres météorologiques.

La capacité maximale de transport de courant électrique d'une ligne à haute tension, parfois appelée « ampacité », est la valeur limite admissible de l'intensité du courant porté par cette ligne, exprimée en ampères. Il est généralement posé comme postulat que cette capacité maximale est une constante dont la valeur est dépendante de la température limite de fonctionnement, elle-même constante et calculée sur la base de paramètres géométriques supposés constants de la ligne à haute tension, et de paramètres météorologiques. La relation entre la capacité maximale de transport de courant électrique et la température limite de fonctionnement est alors exprimée selon une relation d'équilibre thermique fournissant une valeur d'intensité en fonction d'une valeur de température du conducteur de la ligne à haute tension, de paramètres météorologiques et de données intrinsèques du conducteur. Pour un calcul statique de cette capacité maximale, les paramètres météorologiques sont choisis a priori comme les plus défavorables possibles dans l'environnement de la ligne à haute tension pour s'assurer que la résultante calculée de cette façon constitue une valeur limite réellement pertinente vis-à-vis des risques de dépassement de la température limite de fonctionnement. En conséquence, la capacité maximale calculée est généralement largement sous-optimale. Par ailleurs, les paramètres météorologiques étant choisis a priori, les risques réels de dépassement de la température limite de fonctionnement, bien que limités, ne sont généralement pas maîtrisés.

Il est alors aujourd'hui de plus en plus fréquent d'avoir recours à des déterminations dynamiques de capacités maximales de transport de courant électrique de lignes à haute tension, consistant à remplacer au moins une partie des paramètres météorologiques défavorables par des données environnementales plus réalistes localement, issues de mesures. C'est notamment le constat fait par le document intitulé « Dynamic line rating systems for transmission lines: topical report », publié par le U.S. Department of Energy en avril 2014.

Un paramètre relevé comme particulièrement important, notamment dans le document intitulé « Guide for thermal rating calculations of overhead lines », publié par le comité d'étude « B2-lignes aériennes » de l'organisation Cigré, WG B2.43, en décembre 2014, est la vitesse du vent, incluant son sens et son amplitude. Son impact est très sensible sur le refroidissement par convection des lignes à haute tension et donc sur l'augmentation de leurs capacités maximales réelles de transport d'électricité. Malheureusement, il s'agit d'un paramètre généralement considéré comme difficile à mesurer localement et de nombreuses solutions de déterminations dynamiques de capacités maximales de lignes aériennes essaient de le contourner.

Une première solution, appelée CAT-1 et commercialisée par la société « The Valley Group - a Nexans company » prévoit de déployer différents capteurs sur une portion de réseau de transmission de courant électrique à haute tension :

- des capteurs de tension mécanique se présentant sous la forme de jauges de contraintes, déployés sur chaque ligne à haute tension de la portion de réseau considérée pour en estimer la flèche (de l'anglais « sag »), tels que définis dans le brevet US 5,918,288, et
- des capteurs de rayonnement net, déployés sur les pylônes de la portion de réseau considérée pour mesurer des données environnementales incluant l'impact du vent, tels que définis dans le brevet US 5,559,430.

Cette première solution implique l'installation de nombreux capteurs et complique singulièrement les calculs de capacités maximales dans la portion de réseau considérée.

Une deuxième solution, commercialisée par la société « Ampacimon » prévoit elle aussi de déployer des capteurs sur une portion de réseau de transmission de courant électrique à haute tension. Plus précisément, ces capteurs sont déployés sur chaque ligne à haute tension de la portion de réseau considérée pour en mesurer la flèche par analyse fréquentielle de vibrations, comme enseigné dans la demande de brevet WO 2007/031435 A1. Des capteurs de vent, comme enseigné dans la demande de brevet WO 2014/090416 A1, peuvent également être disposés sur les lignes à haute tension.

Cette deuxième solution implique elle aussi l'installation de nombreux capteurs. Par ailleurs, si l'on souhaite se passer des capteurs de vent, elle complique les calculs de capacités maximales dans la portion de réseau considérée puisqu'ils doivent alors se faire en deux temps : exploiter la relation d'équilibre thermique prédéterminée sur la base des hypothèses de flèche mesurée, courant électrique mesuré et autres paramètres connus pour en déduire une estimation indirecte de la vitesse de vent sur chaque ligne conductrice de la portion de réseau ; puis exploiter de nouveau la même relation d'équilibre thermique prédéterminée sur la base de la vitesse de vent estimée indirectement et des autres paramètres connus pour en déduire la capacité maximale de chaque ligne conductrice de la portion de réseau. L'article de Schell et al, intitulé « Quantifying the limits of weather based dynamic line rating methods » et publié à l'occasion de Cigré Canada, Conférence on Power Systems, Halifax, en septembre 2011, expose les bases de ce calcul en deux temps qui s'avère complexe. Une autre possibilité décrite dans le document US 2014/180616 utilise le vent pour déterminer l'ampacité.

Il peut ainsi être souhaité de prévoir un système de détermination dynamique de capacités maximales de transport de courant électrique qui permette de s'affranchir d'au moins une partie des problèmes et contraintes précités.

Il est donc proposé un système de détermination dynamique de capacités maximales de transport de courant électrique relatives à une portion de réseau de transmission de courant électrique à haute tension, comportant :

- des moyens de stockage d'un modèle de la portion de réseau, ce modèle comportant des points singuliers et au moins une ligne conductrice de courant électrique à haute tension entre ces points singuliers, d'une relation d'équilibre thermique prédéterminée, d'une température limite de fonctionnement de chaque ligne conductrice et de paramètres de conduction de chaque ligne conductrice,
- un calculateur, ayant accès aux moyens de stockage, programmé pour calculer au moins une valeur de capacité maximale en chaque point singulier du modèle de portion de réseau à partir de la relation d'équilibre thermique prédéterminée, de chaque température limite de fonctionnement, de chaque paramètre de conduction et de paramètres météorologiques,

comportant en outre des moyens de réception, par le calculateur, de valeurs de vitesses de vent mesurées par un ensemble de stations anémométriques déployées autour de la portion de réseau, le calculateur étant alors programmé pour :

- sélectionner au moins une station anémométrique dans l'ensemble de stations anémométriques,

- appliquer un modèle de propagation de vent depuis ladite au moins une station sélectionnée vers les points singuliers du modèle de portion de réseau, pour l'estimation d'une valeur de vitesse de vent en chaque point singulier à partir des valeurs de vitesses de vent reçues, et
- calculer ladite au moins une capacité maximale en chaque point singulier en prenant en compte ladite valeur de vitesse de vent estimée en chaque point singulier dans la relation d'équilibre thermique prédéterminée.

Ainsi, grâce à un tel système, une estimation directe de la vitesse du vent en plusieurs points sensibles de la portion de réseau considérée est proposée par l'application astucieuse d'un modèle de propagation pouvant se faire sur la base d'un nombre limité de capteurs anémométriques. Cette estimation est ensuite judicieusement exploitée dans la relation d'équilibre thermique prédéterminée pour optimiser le calcul des capacités maximales de la portion de réseau. De nombreux modèles de propagation de vent sont connus de l'homme du métier et peuvent être employés. Du plus simple au plus sophistiqué selon la performance souhaitée, ils présentent tous des résultats surprenants pour le calcul des capacités maximales de transport de courant électrique en au moins chaque point singulier d'une portion de réseau considérée. Celle-ci peut être mieux estimée, à la hausse, pour un coût en capteurs qui peut être limité.

De façon optionnelle, le calculateur est plus précisément programmé pour :

- déterminer un sens principal de vent à partir des valeurs de vitesses de vent reçues, et
- sélectionner la station anémométrique, dite station sous le vent, située la plus en amont dans le sens principal de vent déterminé.

De façon optionnelle également :

- la relation d'équilibre thermique prédéterminée est une équation mathématique équilibrant au moins des expressions mathématiques de gains par effet Joule et énergie solaire avec des expressions mathématiques de pertes par convection et rayonnement électromagnétique, et
- le calculateur est programmé pour prendre en compte ladite valeur de vitesse de vent estimée en chaque point singulier dans l'expression mathématique de perte par convection.

De façon optionnelle également, le calculateur est en outre programmé pour calculer une valeur de température en au moins un point du modèle de portion de réseau pour lequel une valeur de vitesse de vent a été estimée, à partir de la relation d'équilibre thermique prédéterminée, d'une quantité de courant électrique transportée par la ligne conductrice comportant ce point du modèle de portion de réseau, des paramètres de conduction de cette ligne conductrice et des paramètres météorologiques, en prenant en compte ladite valeur de vitesse de vent estimée dans la relation d'équilibre thermique prédéterminée.

De façon optionnelle également, le calculateur est programmé pour déclencher le calcul de ladite au moins une capacité maximale en chaque point singulier à condition que des critères prédéterminés de valeur minimale de vitesse de vent et de cohérence, entre elles, des valeurs de vitesses de vent reçues soient vérifiés.

De façon optionnelle également :

- le critère prédéterminé de valeur minimale de vitesse de vent est défini de la façon suivante : la valeur de vitesse de vent fournie par la station sous le vent doit être supérieure en amplitude à un premier seuil et chaque valeur de vitesse de vent fournie par une station anémométrique autre que la station sous le vent doit être supérieure en amplitude à un deuxième seuil, le deuxième seuil étant inférieur au premier seuil,

- le critère prédéterminé de cohérence, entre elles, des valeurs de vitesses de vent reçues est défini de la façon suivante : les valeurs de vitesses de vent reçues étant vectorielles, l'écart angulaire entre les différents sens de ces valeurs vectorielles doit rester inférieur à un troisième seuil et l'écart en amplitude entre les différentes normes de ces valeurs vectorielles doit rester inférieur à un quatrième seuil.

Il est également proposé une installation de transmission électrique à détermination dynamique de capacités maximales de transport de courant électrique, comportant :

- une portion de réseau de transmission de courant électrique à haute tension comportant des postes électriques locaux et au moins une ligne de transmission ou de distribution de courant électrique à haute tension portée par des pylônes entre ces postes électriques locaux,

- un ensemble de stations anémométriques déployées autour de la portion de réseau, et

- un système de détermination dynamique de capacités maximales de transport de courant électrique selon l'invention.

Il est également proposé un procédé de détermination dynamique de capacités maximales de transport de courant électrique relatives à une portion de réseau de transmission de courant électrique à haute tension, comportant les étapes suivantes :

- établissement d'un modèle de la portion de réseau, ce modèle comportant des points singuliers et au moins une ligne conductrice de courant électrique à haute tension entre ces points singuliers,

- calcul d'au moins une valeur de capacité maximale en chaque point singulier du modèle de portion de réseau à partir d'une relation d'équilibre thermique prédéterminée, d'une température limite de fonctionnement de chaque ligne conductrice, de paramètres de conduction de chaque ligne conductrice et de paramètres météorologiques,

comportant en outre les étapes suivantes :

- mesures de valeurs de vitesses de vent par un ensemble de stations anémométriques déployées autour de la portion de réseau,

- sélection d'au moins une station anémométrique dans l'ensemble de stations anémométriques,

- application d'un modèle de propagation de vent depuis ladite au moins une station sélectionnée vers les points singuliers du modèle de portion de réseau, pour l'estimation d'une valeur de vitesse de vent en chaque point singulier à partir des valeurs de vitesses de vent reçues, et

- calcul de ladite au moins une capacité maximale en chaque point singulier en prenant en compte ladite valeur de vitesse de vent estimée en chaque point singulier dans la relation d'équilibre thermique prédéterminée.

De façon optionnelle :

- chaque ligne conductrice est soumise à une capacité par défaut de transport de courant électrique,

- le calcul de ladite au moins une capacité maximale en chaque point singulier est déclenché à condition que des critères prédéterminés de valeur minimale de vitesse de vent et de cohérence, entre elles, des valeurs de vitesses vent mesurées soient vérifiés, et

- chaque capacité par défaut est remplacée par la plus petite des capacités maximales calculées aux points singuliers formant les extrémités de chaque ligne conductrice respective, dite capacité optimale, si cette capacité optimale est plus élevée que la capacité par défaut correspondante et si les critères prédéterminés sont vérifiés.

De façon optionnelle également :

- le calcul de ladite au moins une capacité maximale en chaque point singulier est déclenché à un instant T et établi par projection temporelle à l'aide du modèle de propagation de vent pour un instant T+H où H>0,

- entre les instants T et T+H, le calcul de ladite au moins une capacité maximale en chaque point singulier est répété et établi par projection temporelle pour l'instant T+H, et

- à l'instant T+H, ladite au moins une valeur de capacité maximale retenue en chaque point singulier est la plus petite des valeurs de capacités maximales correspondantes calculées entre les instants T et T+H.

L'invention sera mieux comprise à l'aide de la description qui va suivre, donnée uniquement à titre d'exemple et faite en se référant aux dessins annexés dans lesquels :

- la figure 1 représente schématiquement la structure générale d'une installation de transmission électrique à détermination dynamique de capacités maximales de transport de courant électrique, selon un mode de réalisation de l'invention,
- la figure 2 illustre les étapes successives d'un procédé de détermination dynamique de capacités maximales de transport de courant électrique mis en oeuvre par l'installation de la figure 1.

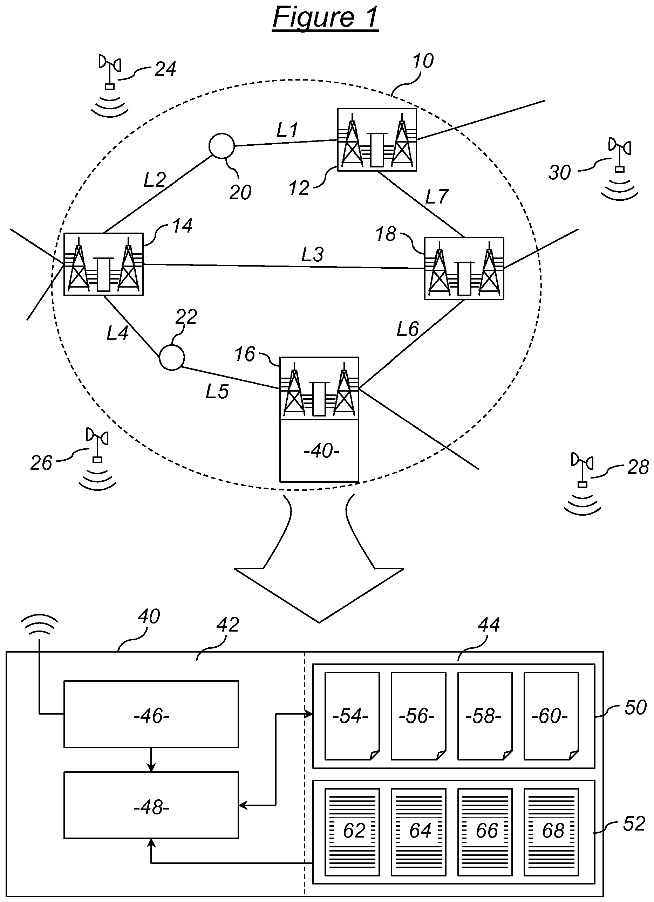

L'installation de transmission électrique illustrée sur la figure 1 comporte une portion 10 d'un réseau de transmission de courant électrique à haute tension comprenant des postes électriques locaux, au moins une ligne de transmission ou de distribution de courant électrique à haute tension entre ces postes et des pylônes pour soutenir chaque ligne de transmission ou de distribution entre deux postes.

Dans cet exemple, la portion de réseau 10 comporte quatre postes électriques locaux 12, 14, 16 et 18, chacun étant défini, par la Commission Electrotechnique Internationale IEC (de l'anglais « International Electrotechnical Commission »), comme une « partie d'un réseau électrique, située en un même lieu, comprenant principalement les extrémités des lignes de transport ou de distribution, de l'appareillage électrique, des bâtiments, et, éventuellement, des transformateurs ». Un poste électrique local est donc un élément du réseau de transmission de courant électrique servant à la fois à la transmission et à la distribution d'électricité. Il permet d'élever la tension électrique pour sa transmission à haute tension, et de la redescendre en vue de sa consommation par des utilisateurs (particuliers ou industriels).

Il est possible d'établir un modèle de cette portion de réseau 10, constitué de points singuliers et d'au moins une ligne conductrice de courant électrique à haute tension entre ces points singuliers. Les postes électriques locaux 12, 14, 16 et 18 se trouvant aux extrémités de lignes de transmission ou de distribution électrique, ils constituent des points singuliers de la portion de réseau 10. D'autres points singuliers peuvent en outre être identifiés. Par exemple, en imposant que chaque ligne conductrice entre deux points singuliers du modèle soit homogène en termes de température limite de fonctionnement, de section de câbles et/ou de tracé rectiligne à +/- 10°, certains pylônes de la portion de réseau 10 peuvent aussi constituer des points singuliers. Il en est par exemple illustré deux sur la figure 1. Un premier pylône formant un point singulier 20 se trouve ainsi disposé sur une ligne de transmission ou de distribution entre les postes électriques locaux 12 et 14 et un deuxième pylône formant un point singulier 22 se trouve disposé sur une ligne de transmission ou de distribution entre les postes électriques locaux 14 et 16.

Dans l'exemple particulier non limitatif de la figure 1 : le poste électrique local 12 est relié électriquement aux postes électriques locaux 14 et 18 par des lignes de transmission ou de distribution portées par des pylônes ; le poste électrique local 14 est relié électriquement aux postes électriques locaux 12, 16 et 18 par des lignes de transmission ou de distribution portées par des pylônes ; et le poste électrique local 16 est relié électriquement aux postes électriques locaux 14 et 18 par des lignes de transmission ou de distribution portées par des pylônes.

Le modèle de la portion de réseau 10 illustrée sur la figure 1 comporte ainsi six points singuliers 12, 14, 16, 18, 20, 22 reliés entre eux par sept lignes conductrices homogènes L1 (entre les points singuliers 12 et 20), L2 (entre les points singuliers 20 et 14), L3 (entre les points singuliers 14 et 18), L4 (entre les points singuliers 14 et 22), L5 (entre les points singuliers 22 et 16), L6 (entre les points singuliers 16 et 18) et L7 (entre les points singuliers 18 et 12). D'autres lignes conductrices sortant de la portion de réseau 10 ont par ailleurs chacune une extrémité raccordée à l'un des quatre postes électriques locaux 12, 14, 16 et 18. Il ne s'agit bien sûr que d'un exemple simple non limitatif fourni pour une bonne illustration de l'invention.

L'installation de transmission électrique illustrée sur la figure 1 comporte en outre un ensemble de stations anémométriques 24, 26, 28, 30 déployées autour de la portion de réseau 10 pour mesurer des valeurs de vitesses de vent. Chaque valeur de vitesse de vent mesurée par l'une quelconque des stations anémométriques 24, 26, 28, 30 comporte un sens du vent et une amplitude du vent exprimée par exemple en m/s. Il s'agit donc d'une valeur vectorielle. Ces stations peuvent être disposées indépendamment des différents points singuliers 12, 14, 16, 18, 20 et 22. Elles disposent de moyens d'émission, par exemple par ondes hertziennes, des valeurs qu'elles mesurent.

Enfin, l'installation de transmission électrique illustrée sur la figure 1 comporte un système 40 de détermination dynamique de capacités maximales de transport de courant électrique relatives à la portion de réseau 10. Il s'agit des capacités maximales de chacune des lignes conductrices qui s'appliquent notamment à leurs extrémités, c'est-à-dire en chaque point singulier, et pour chaque ligne conductrice raccordée à chaque point singulier, du modèle de la portion de réseau 10. Ce système 40, tel que représenté schématiquement sur la figure 1, est par exemple installé dans l'un des postes électriques locaux, en l'occurrence le poste 16. Il pourrait également être installé en toute indépendance de la portion de réseau 10. Il est mis en oeuvre dans un dispositif informatique tel qu'un ordinateur classique et comporte une unité de traitement 42 associée de façon classique à une mémoire 44 (par exemple une mémoire RAM) pour le stockage de fichiers de données et de programmes d'ordinateurs.

L'unité de traitement 42 comporte un récepteur 46 des valeurs mesurées émises par les stations anémométriques 24, 26, 28, 30 et un calculateur 48, par exemple un microprocesseur, apte à traiter les valeurs fournies par le récepteur 46.

La mémoire 44 est partitionnée en une première zone 50 de stockage de données de traitement et une deuxième zone 52 de stockage de programmes d'ordinateur. Cette partition est purement fonctionnelle, choisie pour une présentation claire du système 40, mais ne reflète pas nécessairement l'organisation réelle de la mémoire 44.

La première zone de stockage 50 comporte tout d'abord des données 54 relatives au modèle, détaillé ci-dessus, de la portion de réseau 10. Ces données comprennent des paramètres d'identification et de caractérisation des points singuliers 12, 14, 16, 18, 20, 22 et des lignes conductrices homogènes L1, L2, L3, L4, L5, L6, L7, incluant, outre les considérations topologiques ou géographiques, une température limite de fonctionnement et des paramètres de conduction pour chaque ligne conductrice.

La première zone de stockage 50 comporte en outre des données 56 relatives à une relation d'équilibre thermique prédéterminée. Cette relation est par exemple une équation mathématique équilibrant au moins des expressions mathématiques de gains par effet Joule et énergie solaire avec des expressions mathématiques de pertes par convection et rayonnement électromagnétique. Il peut notamment s'agir d'une relation issue de l'équation IEEE en régime permanent, définie dans le document intitulé « IEEE standard for calculating the current-temperature relationship of bare overhead conductors », publié par IEEE Power Engineering Society sous la référence IEEE Std 738™-2006, en janvier 2007. Il peut aussi s'agir d'une relation issue de l'équation Cigré en régime permanent, définie dans le document intitulé « Thermal behaviour of overhead conductors », publié par le comité d'étude « B2-lignes aériennes » de l'organisation Cigré, WG 22.12, en août 2002, ou précisée dans le document « Guide for thermal rating calculations of overhead lines » précédemment cité. Elle prend par exemple la forme générale :

$$P_J + P_S = P_C + P_R \, ,$$

où $P_J$ est le gain thermique par effet Joule, $P_S$ le gain thermique par énergie solaire, $P_C$ la perte thermique par convection et $P_R$ la perte thermique par rayonnement électromagnétique. On se reportera vers les documents cités ci-dessus pour des exemples d'expressions détaillées de chacun(e) de ces gains ou pertes.

La première zone de stockage 50 comporte en outre des données 58 relatives à des paramètres météorologiques généraux portant sur la zone géographique dans laquelle se trouve la portion de réseau 10. Ces paramètres peuvent être choisis a priori comme les plus défavorables possibles dans l'environnement de la portion de réseau 10. Ils peuvent relever de zonages, calculs statistiques, mesures régulières, etc. Ils comportent par exemple des valeurs de température ambiante et d'ensoleillement qui sont fonction du lieu et de la saison. On notera que certaines des données 58 peuvent en variante être remplacées ou mises à jour dynamiquement par des valeurs fournies au calculateur 48 via le récepteur 46. En particulier, des valeurs de températures extérieures en différents points de la portion de réseau 10 peuvent être fournies dynamiquement au calculateur 48 pour un meilleur traitement réalisé par ce dernier par leur prise en compte dans la relation d'équilibre thermique prédéterminée 56.

La première zone de stockage 50 comporte enfin des données 60 relatives à un modèle de propagation de vent. De nombreux modèles de propagation plus ou moins sophistiqués sont connus. Il peut par exemple s'agir d'un modèle de projection linéaire proportionnel selon lequel la vitesse de propagation est prise arbitrairement égale à la l'amplitude de la vitesse du vent, tandis que le sens de la propagation, considérée comme plane, est celui du vent. Un tel modèle, particulièrement simple, est loin d'être parfait, mais il est déjà susceptible de fournir de bons résultats pour une estimation dynamique des capacités maximales mentionnées précédemment. Il permet de construire un historique des valeurs de vitesse de vent pour chaque point du modèle 54 de la portion de réseau 10, et notamment pour chaque point singulier. Un tel historique s'enrichit progressivement au gré des mesures prises par les stations anémométriques 24, 26, 28, 30.

La deuxième zone de stockage 52 telle qu'illustrée sur la figure 1 comporte fonctionnellement quatre programmes d'ordinateurs ou quatre fonctions d'un même programme d'ordinateur 62, 64, 66, 68. On notera en effet que les programmes d'ordinateurs 62, 64, 66, 68 sont présentés comme distincts, mais cette distinction est purement fonctionnelle. Ils pourraient tout aussi bien être regroupés selon toutes les combinaisons possibles en un ou plusieurs logiciels. Leurs fonctions pourraient aussi être au moins en partie micro programmées ou micro câblées dans des circuits intégrés dédiés. Ainsi, en variante, le dispositif informatique mettant en oeuvre l'unité de traitement 42 et sa mémoire 44 pourrait être remplacé par un dispositif électronique composé uniquement de circuits numériques (sans programme d'ordinateur) pour la réalisation des mêmes actions.

Le premier programme d'ordinateur 62 comporte des lignes d'instructions pour l'exécution d'une sélection de station anémométrique, dite station sous le vent, parmi les stations 24, 26, 28, 30 à disposition, à partir de valeurs de vitesses de vent mesurées et transmises au microprocesseur 48 par l'intermédiaire du récepteur 46.

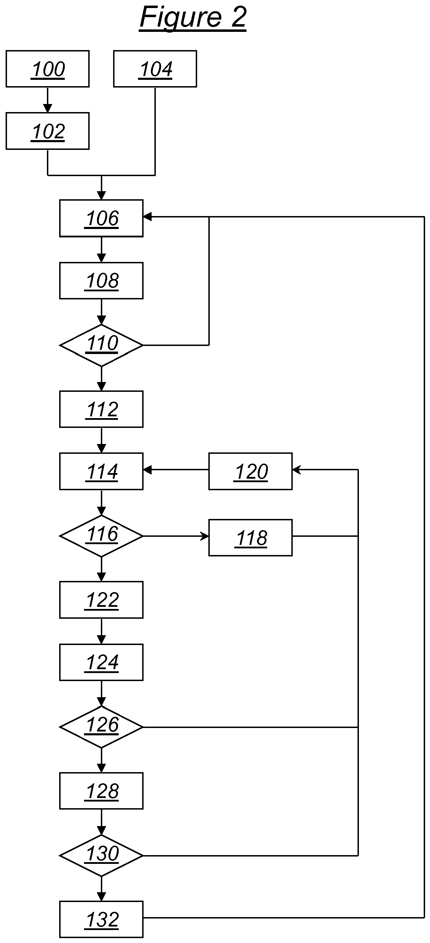

Un exemple non limitatif de fonctionnement de ce premier programme sera détaillé en référence à la figure 2. En variante et selon la complexité du modèle 60 de propagation de vent retenu, un tel programme pourrait sélectionner plusieurs stations anémométriques parmi celles à disposition.

Le deuxième programme d'ordinateur 64 comporte des lignes d'instructions pour l'application du modèle 60 de propagation de vent depuis la station sous le vent vers les points singuliers 12, 14, 16, 18, 20, 22 du modèle 54 de portion de réseau 10, pour l'estimation de valeurs successives de vitesses de vent en chaque point singulier à partir de valeurs successives de vitesses de vent mesurées par la station sous le vent. Un exemple non limitatif de fonctionnement de ce deuxième programme sera détaillé en référence à la figure 2.

Le troisième programme d'ordinateur 66 comporte des lignes d'instructions pour l'exécution du calcul d'au moins une valeur de capacité maximale de transport de courant électrique en chaque point singulier 12, 14, 16, 18, 20 et 22 du modèle 54 de portion de réseau 10 à partir :

- de la relation d'équilibre thermique prédéterminée 56,
- de chaque température limite de fonctionnement et de chaque paramètre de conduction de réseau enregistrés avec les données du modèle 54 de la portion de réseau 10,
- des paramètres météorologiques généraux 58, et
- d'éventuels paramètres météorologiques fournis dynamiquement au calculateur 48, tels que des températures extérieures mesurées,

en prenant en compte, dans la relation d'équilibre thermique prédéterminée 56, les valeurs de vitesses de vent estimées en tous les points singuliers 12, 14, 16, 18, 20, 22 par exécution du deuxième programme 64.

Plus précisément et conformément à l'enseignement du document « Guide for thermal rating calculations of overhead lines » précédemment cité, les valeurs de vitesses de vent peuvent être prises en compte dans l'expression mathématique de perte par convection $P_C$ de l'expression $P_J + P_S = P_C + P_R$.

Dans l'exemple de la figure 1, ce sont deux valeurs de capacités maximales qui peuvent être calculées au point singulier 12, l'une pour la ligne conductrice L1, l'autre pour la ligne conductrice L7. Trois valeurs de capacités maximales peuvent être calculées au point singulier 14, l'une pour la ligne conductrice L2, une autre pour la ligne conductrice L3, la dernière pour la ligne conductrice L4. Deux valeurs de capacités maximales peuvent être calculées au point singulier 16, l'une pour la ligne conductrice L5, l'autre pour la ligne conductrice L6. Trois valeurs de capacités maximales peuvent être calculées au point singulier 18, l'une pour la ligne conductrice L6, une autre pour la ligne conductrice L3, la dernière pour la ligne conductrice L7. Deux valeurs de capacités maximales peuvent être calculées au point singulier 20, l'une pour la ligne conductrice L1, l'autre pour la ligne conductrice L2. Deux valeurs de capacités maximales peuvent être calculées au point singulier 22, l'une pour la ligne conductrice L4, l'autre pour la ligne conductrice L5.

Le quatrième programme d'ordinateur 68 comporte des lignes d'instructions pour l'exécution optionnelle du calcul d'une valeur de température réelle en chaque point singulier 12, 14, 16, 18, 20 et 22 du modèle 54 de la portion de réseau 10 à partir :

- de la même relation d'équilibre thermique prédéterminée 56,
- d'une quantité de courant électrique transportée réellement par chaque ligne conductrice et de chaque paramètre de conduction de réseau enregistré avec les données du modèle 54 de portion de réseau 10,
- des paramètres météorologiques généraux 58, et
- d'éventuels paramètres météorologiques fournis dynamiquement au calculateur 48, tels que des températures extérieures mesurées,

en prenant en compte, dans la relation d'équilibre thermique prédéterminée 56, les valeurs de vitesses de vent estimées en tous les points singuliers 12, 14, 16, 18, 20, 22 par exécution du deuxième programme 64.

Un procédé de détermination dynamique de capacités maximales de transport de courant électrique dans la portion de réseau 10, mis en oeuvre par exécution des programmes d'ordinateurs 62, 64, 66, 68 à l'aide du microprocesseur 48, va maintenant être détaillé en référence à la figure 2.

Au cours d'une étape préalable 100 de préparation du système 40, la portion de réseau 10 dans laquelle est destinée à s'appliquer cette détermination dynamique de capacités maximales est définie par son périmètre, les postes électriques locaux qu'elle contient et les lignes de transmission ou de distribution entre ces postes. L'ensemble de stations anémométriques déployées autour de la portion de réseau 10 définie est par ailleurs sélectionné.

De façon avantageuse, mais sans contrainte ni obligation, une telle portion de réseau 10 présente l'une ou plusieurs des caractéristiques suivantes :

- son périmètre géographique n'est pas trop étendu, de sorte qu'elle présente des caractéristiques géographiques homogènes en termes de relief (il doit rester relativement plat) et d'obstacles (ils doivent être aussi peu nombreux que possible),
- elle constitue une « poche électrique » : cela signifie qu'elle constitue une zone autonome répondant à des règles électrotechniques locales homogènes en termes d'alimentation, transport et fourniture d'électricité,
- elle est alimentée par un parc éolien significatif engendrant des demandes en capacités de transport qui augmentent avec la force du vent : c'est alors tout l'intérêt de l'invention que de pouvoir estimer dynamiquement à la hausse les capacités maximales de transport de la portion de réseau 10 en fonction de la vitesse du vent.

Au cours d'une étape suivante 102 de modélisation de la portion de réseau 10 définie précédemment, le modèle 54 de cette portion de réseau 10 est établi et enregistré en mémoire 44 à partir d'une cartographie des postes électriques locaux et des lignes de transmission ou de distribution qu'elle contient. Cette étape 102 peut être exécutée de façon automatique à l'aide d'un programme d'ordinateur (non illustré) spécifiquement implémenté dans le système 40. Il s'agit principalement de déterminer les points singuliers du modèle 54 : ceux-ci incluent tous les postes électriques locaux ainsi que certains pylônes se situant aux extrémités de tronçons homogènes de lignes à haute tension en termes de tracé rectiligne (une déviation angulaire à +/- 10% pouvant par exemple être admise), de sections de câbles et de températures limites de fonctionnement. On obtient ainsi par exemple le modèle 54 illustré sur la figure 1 par les points singuliers 12, 14, 16, 18, 20, 22 et les lignes conductrices homogènes L1, L2, L3, L4, L5, L6, L7.

Au cours d'une étape de paramétrage 104, qui peut avoir lieu avant, pendant ou après les étapes 100 et 102, au moins une valeur $V_{min}$ de vitesse minimale de vent, une valeur $\Delta V_{max}$ de variation maximale de vitesses de vent entre stations anémométriques et une valeur $\Delta\theta_{max}$ de variation angulaire maximale de directions de vent entre stations anémométriques sont prédéterminées. La valeur $V_{min}$ permet de définir une valeur minimale de vitesse de vent en deçà de laquelle il n'est pas jugé utile d'exécuter les programmes d'ordinateurs 66 et 68, voire le programme d'ordinateur 64, imposant ainsi un premier critère prédéterminé conditionnant le déclenchement du calcul des capacités maximales de transport de courant électrique en chaque point singulier. Les valeurs $\Delta V_{max}$ et $\Delta\theta_{max}$ permettent de définir des valeurs maximales de variations des mesures entre stations anémométriques au-delà desquelles il n'est pas jugé utile d'exécuter les programmes d'ordinateurs 66 et 68, voire le programme d'ordinateur 64, imposant ainsi un deuxième critère prédéterminé de cohérence de ces mesures entre elles conditionnant le déclenchement du calcul des capacités maximales de transport de courant électrique en chaque point singulier. Ces critères permettent de tirer au mieux profit du procédé de la figure 2 sachant qu'il fournit des résultats performants lorsque les mesures de vitesses de vent fournies par les différentes stations anémométriques sont cohérentes entre elles et lorsque le vent mesuré dépasse une certaine valeur à déterminer spécifiquement en fonction de chaque contexte dans lequel l'invention est mise en oeuvre.

Ensuite, au cours d'une étape de mesure 106, chaque station anémométrique 24, 26, 28, 30 mesure localement une succession de valeurs de vitesses de vent. Chaque valeur mesurée est vectorielle et transmise au récepteur 46 du système 40.

Lors d'une étape 108, le microprocesseur 48 du système 40 déclenche l'exécution du premier programme d'ordinateur 62. Au cours de cette étape, il détermine un sens principal de vent à partir des dernières valeurs de vitesses de vent reçues. Cela peut se faire de façon connue en soi par un calcul de moyenne angulaire des sens de vent mesurés par les différentes stations anémométriques 24, 26, 28, 30. A partir de cette valeur de sens principal du vent, le microprocesseur 48 détermine la station anémométrique sous le vent, c'est-à-dire celle, parmi les stations 24, 26, 28, 30, qui est située la plus en amont dans le sens principal de vent déterminé.

L'étape 108 est suivie d'un test 110 au cours duquel les critères de déclenchement du calcul des capacités maximales de transport de courant électrique en chaque point singulier de la portion de réseau 10 sont vérifiés. Le premier critère, relatif à la valeur $V_{min}$, se décline par exemple en deux critères portant sur des seuils $V_{min}[1]$ et $V_{min}[2]$ selon lesquels la valeur de vitesse de vent fournie par la station sous le vent doit être supérieure en amplitude à $V_{min}[1]$ et chaque valeur de vitesse de vent fournie par une station anémométrique autre que la station sous le vent doit être supérieure en amplitude à $V_{min}[2]$, avec $V_{min}[2] < V_{min}[1]$. On peut par exemple choisir $V_{min}[1]$ = 5 m/s et $V_{min}[2]$ = 2 m/s. Le deuxième critère, de cohérence, impose que l'écart angulaire entre les différents sens des valeurs vectorielles mesurées reste inférieur à $\Delta\theta_{max}$ et l'écart en amplitude entre les différentes normes des valeurs vectorielles mesurées reste inférieur $\Delta V_{max}$. Il peut par exemple être toléré un écart de 10% autour des valeurs moyennes.

Lorsque que ces critères sont vérifiés, le procédé passe à une étape suivante 112. Sinon, il revient à l'étape 106 pour une nouvelle série de mesures.

Au cours de l'étape 112, une initialisation temporelle est déclenchée par le microprocesseur 48. Il est établi un premier instant T à partir duquel il est décidé de commencer le calcul dynamique des capacités maximales par projection temporelle à l'aide du modèle 60 de propagation de vent pour un deuxième instant T+H, où H>0, à partir duquel ces capacités maximales calculées pourront, le cas échéant, être appliquées à la portion de réseau 10. En considérant Dmax la distance maximale entre la station sous le vent et le point singulier le plus éloigné de la portion de réseau 10, et au vu de $V_{min}[1]$ qui est la vitesse minimale mesurée en sortie de l'étape 110, pour que l'on soit sûr de pouvoir estimer la vitesse du vent en chaque point singulier de la portion de réseau 10 par projection temporelle à l'instant T+H, il est préférable de s'assurer que $H \geq Dmax/V_{min}[1]$. Ainsi, H = 90 mn est suffisant pour une distance maximale de 27 km.

En outre, au cours de cette même étape 112, un indice temporel t incrémentable par pas de $\Delta t$ entre T et T+H est initialisé à t=T. Pour H = 90 mn, on peut par

exemple choisir $\Delta t = 6$ mn.

En outre, chaque ligne conductrice étant soumise à une capacité par défaut de transport de courant électrique par exemple déterminée selon les techniques connues de l'art antérieur, il peut être associé une capacité opérationnelle par défaut à chacun des points singuliers de la portion de réseau 10 pour chacune des lignes conductrices auxquelles il est raccordé.

Enfin, pour chaque point singulier et chaque ligne conductrice à laquelle il est raccordée, une valeur C de capacité maximale est initialisée à l'infini ($+\infty$).

L'étape 112 est suivie d'une boucle d'étapes 114, 116, 118, 120, 122, 124, 126, 128, 130 qui est exécutée pour au moins chacun des points singuliers du modèle 54 de la portion de réseau 10 et pour chacune des lignes conductrices auxquelles il est raccordé.

Ainsi, pour un point singulier considéré et pour une ligne conductrice considérée à laquelle il est raccordé, lors de l'étape 114, réalisée par exécution du deuxième programme d'ordinateur 64, le modèle de propagation de vent est appliqué à au moins une valeur de vitesse de vent mesurée par la station anémométrique sous le vent au cours d'une période se terminant à l'instant t pour déterminer par projection temporelle, si cela est possible compte tenu des vitesses mesurées et de la distance entre la station sous le vent et le point singulier considéré, une valeur de vitesse de vent au point singulier considéré à l'instant T+H.

Ensuite, au cours d'une étape de test 116, le premier critère de déclenchement du calcul de la capacité maximale de transport de courant électrique au point singulier considéré et pour la ligne conductrice considérée peut de nouveau être vérifié sur la base de la valeur de vitesse de vent déterminée à l'étape 114. Par exemple, elle doit être supérieure en amplitude à $V_{min}[1]$,

Si ce n'est pas le cas, le procédé passe à une étape suivante 118 au cours de laquelle la capacité maximale au point singulier considéré à l'instant t est mise à sa valeur opérationnelle par défaut. Puis il passe à une étape 120 d'incrémentation de t à t+$\Delta t$ avant de revenir à l'étape 114.

Si la valeur de vitesse de vent déterminée à l'étape 114 vérifie le critère de l'étape 116, le procédé passe à une étape 122 de calcul dynamique de la capacité maximale de transport de courant électrique au point singulier considéré pour la ligne conductrice considérée par exécution du troisième programme d'ordinateur 66 en tenant compte de la valeur de vitesse de vent déterminée à l'étape 114 dans la relation 56 d'équilibre thermique prédéterminé et en tenant compte également des propriétés de la ligne conductrice considérée. Il peut alors en être déduit une valeur de capacité maximale calculée à l'instant t pour l'instant T+H.

Puis le procédé passe éventuellement à une étape optionnelle 124 de calcul dynamique d'une valeur de température réelle au point singulier considéré pour la ligne conductrice considérée par exécution du quatrième programme d'ordinateur 68 en tenant compte des mêmes paramètres qu'à l'étape précédente et de la quantité de courant électrique réellement transportée. Cette étape optionnelle peut par exemple servir à valider la pertinence du calcul dynamique des capacités maximales en comparant les valeurs de températures réelles estimées à des mesures de températures réelles relevées par capteurs. D'une façon plus générale, cette étape de calcul peut être réalisée en n'importe quel point de la portion de réseau 10 pourvu d'un capteur de température ou de tout autre moyen d'évaluation d'une température de câble (directement ou indirectement par la mesure de la flèche, de la tension mécanique ou de la fréquence vibratoire du câble par exemple).

Au cours d'une étape de test 126 suivante, la capacité maximale dynamiquement calculée à l'étape 122 est comparée à la capacité opérationnelle par défaut du point singulier considéré pour la ligne conductrice considérée. Si la valeur calculée dynamiquement est inférieure ou égale à la capacité opérationnelle par défaut, c'est cette dernière qui est retenue comme valeur calculée à l'étape 122, puis le procédé retourne à l'étape 120 tant que l'indice temporel t est inférieur à T+H.

Si la valeur calculée dynamiquement est supérieure à la capacité opérationnelle par défaut ou si l'instant T+H a été atteint à l'étape 126, le procédé passe à une étape suivante 128. Au cours de cette étape 128, la capacité maximale calculée dynamiquement à l'étape 122 est comparée à la valeur C. Si elle est supérieure, C reste inchangée, sinon C est remplacée par cette capacité maximale calculée à l'instant t pour l'instant T+H lors de l'étape 122.

Ensuite, une étape de test 130 est réalisée sur l'indice temporel t. Si ce dernier est inférieur à T+H, le procédé retourne à l'étape 120.

Sinon, il passe à une étape finale 132 au cours de laquelle la dernière valeur de C est retenue en tant que capacité maximale de transport électrique à l'instant T+H au point singulier considéré pour la ligne conductrice considérée. Il s'agit, compte tenu de l'étape 128, de la plus petite des valeurs de capacité maximale dynamiquement calculées ayant passé le test de l'étape 126. Par ailleurs, une fois la boucle d'étapes 114 à 130 exécutée pour au moins chacun des points singuliers du modèle 54 de la portion de réseau 10, les capacités maximales calculées peuvent être éventuellement revues à la baisse de la façon suivante : pour chaque ligne conductrice, les capacités maximales dynamiquement calculées pour l'instant T+H à ses deux extrémités sont comparées et c'est la valeur minorante qui est finalement retenue aux deux points singuliers concernés pour la ligne conductrice considérée. Ainsi, chaque capacité par défaut est remplacée par la plus petite des capacités maximales calculées aux points singuliers formant les extrémités de chaque ligne conductrice respective, dite capacité optimale, si cette capacité optimale est plus élevée que la capacité par défaut correspondante et si les critères prédéterminés indiqués précédemment sont vérifiés.

Il appartient ensuite à un opérateur de la portion de réseau 10 d'appliquer tout ou partie des valeurs de capacités optimales à partir de l'instant t+H de manière à répondre aux sollicitations de fournisseurs ou consommateurs d'électricité.

Suite à l'étape 132, le procédé retourne à l'étape 106 pour une nouvelle série de mesures.

Il apparaît clairement qu'un système de détermination dynamique de capacités maximales de transport de courant électrique tel que celui décrit précédemment permet de prendre en compte simplement et astucieusement des mesures de vitesses de vent pour obtenir une estimation plus favorable de ces capacités maximales. Etant donné que l'effet refroidissant du vent s'accompagne d'une capacité de production d'électricité croissante lorsque la portion de réseau concernée est raccordée à un parc éolien, c'est notamment dans ce contexte que l'invention présente ses meilleurs résultats.

On notera par ailleurs que l'invention n'est pas limitée au mode de réalisation décrit précédemment.

En particulier, la topologie de la portion de réseau considérée peut être tout à fait quelconque, celle de la figure 1 n'ayant été choisie à titre illustratif que pour sa simplicité.

Par ailleurs, les stations anémométriques 24, 26, 28, 30 ont été illustrées comme disposées indépendamment de la portion de réseau 10, mais elles pourraient aussi être installées dans au moins une partie des postes électriques locaux, notamment ceux situés en périphérie de la portion de réseau (ce qui est le cas des quatre postes illustrés sur la figure 1).

Par ailleurs également, le modèle 60 de propagation de vent par projection linéaire pris comme exemple avantageux pourrait être remplacé par tout autre modèle connu, l'adaptation de l'invention à un modèle de propagation connu autre que celui présenté précédemment étant à la portée de l'homme du métier.

Par ailleurs également, le procédé détaillé en référence à la figure 2 peut être décliné selon un grand nombre de variantes qu'il est impossible de lister de façon exhaustive, seules les étapes générales suivantes devant nécessairement être mises en oeuvre :

- établissement d'un modèle de la portion de réseau, ce modèle étant constitué de points singuliers et d'au moins une ligne conductrice de courant électrique à haute tension entre ces points singuliers,
- mesures de valeurs de vitesses de vent par un ensemble de stations anémométriques déployées autour de la portion de réseau,
- sélection d'au moins une station anémométrique dans l'ensemble de stations anémométriques,
- application d'un modèle de propagation de vent depuis ladite au moins une station sélectionnée vers les points singuliers du modèle de portion de réseau, pour l'estimation d'une valeur de vitesse de vent en chaque point singulier à partir des valeurs de vitesses de vent reçues, et

- calcul d'au moins une valeur de capacité maximale en chaque point singulier du modèle de portion de réseau à partir d'une relation d'équilibre thermique prédéterminée, d'une température limite de fonctionnement de chaque ligne conductrice, de paramètres de conduction de chaque ligne conductrice et de paramètres météorologiques, en prenant en compte ladite valeur de vitesse de vent estimée en chaque point singulier dans la relation d'équilibre thermique prédéterminée.

On notera en particulier que les calculs de capacités maximales peuvent être exécutés pour d'autres points du modèle de la portion de réseau que les points singuliers, notamment tout au long d'au moins une partie des lignes conductrices.

Il apparaîtra plus généralement à l'homme de l'art que diverses modifications peuvent être apportées au mode de réalisation décrit ci-dessus, à la lumière de l'enseignement qui vient de lui être divulgué. Dans les revendications qui suivent, les termes utilisés ne doivent pas être interprétés comme limitant les revendications au mode de réalisation exposé dans la présente description, mais doivent être interprétés pour y inclure tous les équivalents que les revendications visent à couvrir du fait de leur formulation et dont la prévision est à la portée de l'homme de l'art en appliquant ses connaissances générales à la mise en oeuvre de l'enseignement qui vient de lui être divulgué.

## Revendications

1. Système (40) de détermination dynamique de capacités maximales de transport de courant électrique relatives à une portion (10) de réseau de transmission de courant électrique à haute tension, comportant :

   - des moyens (44) de stockage d'un modèle (54) de la portion de réseau, ce modèle (54) comportant des points singuliers (12, 14, 16, 18, 20, 22) et au moins une ligne (L1, L2, L3, L4, L5, L6, L7) conductrice de courant électrique à haute tension entre ces points singuliers, d'une relation d'équilibre thermique prédéterminée (56), d'une température limite de fonctionnement de chaque ligne conductrice et de paramètres de conduction de chaque ligne conductrice,
   - un calculateur (48), ayant accès aux moyens de stockage (44), programmé (62, 64, 66, 68) pour calculer au moins une valeur de capacité maximale en chaque point singulier (12, 14, 16, 18, 20, 22) du modèle (54) de portion de réseau à partir de la relation d'équilibre thermique prédéterminée (56), de chaque température limite de fonctionnement, de chaque paramètre de conduction et de paramètres météorologiques (58),

**caractérisé en ce qu'**il comporte en outre des moyens (46) de réception, par le calculateur (48), de valeurs de vitesses de vent mesurées par un ensemble de stations anémométriques déployées autour de la portion de réseau, et **en ce que** le calculateur (48) est programmé pour :

- sélectionner au moins une station anémométrique dans l'ensemble de stations anémométriques,
- appliquer un modèle (60) de propagation de vent depuis ladite au moins une station sélectionnée vers les points singuliers (12, 14, 16, 18, 20, 22) du modèle (54) de portion de réseau, pour l'estimation d'une valeur de vitesse de vent en chaque point singulier à partir des valeurs de vitesses de vent reçues, et
- calculer ladite au moins une capacité maximale en chaque point singulier en prenant en compte ladite valeur de vitesse de vent estimée en chaque point singulier dans la relation d'équilibre thermique prédéterminée (56).

2. Système (40) de détermination dynamique de capacités maximales de transport de courant électrique selon la revendication 1, dans lequel le calculateur (48) est plus précisément programmé (62) pour :

- déterminer un sens principal de vent à partir des valeurs de vitesses de vent reçues, et
- sélectionner la station anémométrique, dite station sous le vent, située la plus en amont dans le sens principal de vent déterminé.

3. Système (40) de détermination dynamique de capacités maximales de transport de courant électrique selon la revendication 1 ou 2, dans lequel :

- la relation d'équilibre thermique prédéterminée (56) est une équation mathématique équilibrant au moins des expressions mathématiques de gains par effet Joule et énergie solaire avec des expressions mathématiques de pertes par convection et rayonnement électromagnétique, et
- le calculateur (48) est programmé (66, 68) pour prendre en compte ladite valeur de vitesse de vent estimée en chaque point singulier dans l'expression mathématique de perte par convection.

4. Système (40) de détermination dynamique de capacités maximales de transport de courant électrique selon l'une quelconque des revendications 1 à 3, dans lequel le calculateur (48) est en outre programmé (68) pour calculer une valeur de température en au moins un point du modèle (54) de portion de réseau pour lequel une valeur de vitesse de vent a été estimée, à partir de la relation d'équilibre thermique prédéterminée (56), d'une quantité de courant électrique transportée par la ligne conductrice comportant ce point du modèle (54) de portion de réseau, des paramètres de conduction de cette ligne conductrice et des paramètres météorologiques (58), en prenant en compte ladite valeur de vitesse de vent estimée dans la relation d'équilibre thermique prédéterminée (56).

5. Système (40) de détermination dynamique de capacités maximales de transport de courant électrique selon l'une quelconque des revendications 1 à 4, dans lequel le calculateur (48) est programmé pour déclencher le calcul de ladite au moins une capacité maximale en chaque point singulier à condition que des critères prédéterminés de valeur minimale de vitesse de vent et de cohérence, entre elles, des valeurs de vitesses de vent reçues soient vérifiés.

6. Système (40) de détermination dynamique de capacités maximales de transport de courant électrique selon la revendication 5, dans lequel :

- le critère prédéterminé de valeur minimale de vitesse de vent est défini de la façon suivante : la valeur de vitesse de vent fournie par la station sous le vent doit être supérieure en amplitude à un premier seuil et chaque valeur de vitesse de vent fournie par une station anémométrique autre que la station sous le vent doit être supérieure en amplitude à un deuxième seuil, le deuxième seuil étant inférieur au premier seuil,
- le critère prédéterminé de cohérence, entre elles, des valeurs de vitesses de vent reçues est défini de la façon suivante : les valeurs de vitesses de vent reçues étant vectorielles, l'écart angulaire entre les différents sens de ces valeurs vectorielles doit rester inférieur à un troisième seuil et l'écart en amplitude entre les différentes normes de ces valeurs vectorielles doit rester inférieur à un quatrième seuil.

7. Installation de transmission électrique à détermination dynamique de capacités maximales de transport de courant électrique, comportant :

- une portion (10) de réseau de transmission de courant électrique à haute tension comportant des postes électriques locaux (12, 14, 16, 18) et au moins une ligne de transmission ou de distribution de courant électrique à haute tension portée par des pylônes (20, 22) entre ces postes électriques locaux,
- un ensemble de stations anémométriques (24, 26, 28, 30) déployées autour de la portion de réseau (10), et

- un système (40) de détermination dynamique de capacités maximales de transport de courant électrique selon l'une quelconque des revendications 1 à 6.

8. Procédé de détermination dynamique de capacités maximales de transport de courant électrique relatives à une portion (10) de réseau de transmission de courant électrique à haute tension, comportant les étapes suivantes :

- établissement (102) d'un modèle (54) de la portion de réseau (10), ce modèle (54) comportant des points singuliers (12, 14, 16, 18, 20, 22) et au moins une ligne (L1, L2, L3, L4, L5, L6, L7) conductrice de courant électrique à haute tension entre ces points singuliers,
- calcul (114, 116, 118, 120, 122, 124, 126, 128, 130, 132) d'au moins une valeur de capacité maximale en chaque point singulier (12, 14, 16, 18, 20, 22) du modèle (54) de portion de réseau (10) à partir d'une relation d'équilibre thermique prédéterminée (56), d'une température limite de fonctionnement de chaque ligne conductrice (L1, L2, L3, L4, L5, L6, L7), de paramètres de conduction de chaque ligne conductrice (L1, L2, L3, L4, L5, L6, L7) et de paramètres météorologiques (58),

**caractérisé en ce qu'**il comporte en outre les étapes suivantes :

- mesures (106) de valeurs de vitesses de vent par un ensemble de stations anémométriques (24, 26, 28, 30) déployées autour de la portion de réseau (10),
- sélection (108) d'au moins une station anémométrique dans l'ensemble de stations anémométriques (24, 26, 28, 30),
- application (114) d'un modèle (60) de propagation de vent depuis ladite au moins une station sélectionnée vers les points singuliers (12, 14, 16, 18, 20, 22) du modèle (54) de portion de réseau (10), pour l'estimation d'une valeur de vitesse de vent en chaque point singulier à partir des valeurs de vitesses de vent reçues, et
- calcul (114, 116, 118, 120, 122, 124, 126, 128, 130, 132) de ladite au moins une capacité maximale en chaque point singulier en prenant en compte ladite valeur de vitesse de vent estimée en chaque point singulier dans la relation d'équilibre thermique prédéterminée (56).

9. Procédé de détermination dynamique de capacités maximales de transport de courant électrique selon la revendication 8, dans lequel :

- chaque ligne conductrice (L1, L2, L3, L4, L5, L6, L7) est soumise à une capacité par défaut de transport de courant électrique,
- le calcul (114, 116, 118, 120, 122, 124, 126, 128, 130, 132) de ladite au moins une capacité maximale en chaque point singulier est déclenché (112) à condition (110) que des critères prédéterminés de valeur minimale de vitesse de vent et de cohérence, entre elles, des valeurs de vitesses vent mesurées soient vérifiés, et
- chaque capacité par défaut est remplacée (128, 132) par la plus petite des capacités maximales calculées aux points singuliers formant les extrémités de chaque ligne conductrice respective, dite capacité optimale, si cette capacité optimale est plus élevée que la capacité par défaut correspondante et si les critères prédéterminés sont vérifiés.

10. Procédé de détermination dynamique de capacités maximales de transport de courant électrique selon la revendication 9, dans lequel :

- le calcul (114, 116, 118, 120, 122, 124, 126, 128, 130, 132) de ladite au moins une capacité maximale en chaque point singulier est déclenché (112) à un instant T et établi par projection temporelle (114) à l'aide du modèle (60) de propagation de vent pour un instant T+H où H>0,
- entre les instants T et T+H, le calcul (114, 116, 118, 120, 122, 124, 126, 128, 130, 132) de ladite au moins une capacité maximale en chaque point singulier est répété et établi par projection temporelle pour l'instant T+H, et
- à l'instant T+H, ladite au moins une valeur de capacité maximale retenue en chaque point singulier est la plus petite des valeurs de capacités maximales correspondantes calculées entre les instants T et T+H.

**Patentansprüche**

1. System (40) zur dynamischen Bestimmung von maximalen Stromtragfähigkeiten, die sich auf einen Abschnitt (10) eines Hochspannungs-Stromübertragungsnetzes beziehen, umfassend:

- Mittel (44) zum Speichern eines Modells (54) des Netzabschnitts, wobei dieses Modell (54) einzelne Punkte (12, 14, 16, 18, 20, 22) und mindestens eine Leitung (L1, L2, L3, L4, L5, L6, L7) umfasst, die zwischen diesen einzelnen Punkten Hochspannungsstrom leitet, einer vorbestimmten thermischen Gleichgewichtsbeziehung (56), einer Betriebsgrenztemperatur jeder leitenden Leitung und von Leitungsparametern jeder leitenden Leitung,
- einen auf die Speichermittel (44) Zugriff besitzenden Rechner (48), der dafür programmiert (62, 64, 66, 68) ist, mindestens einen maximalen Fähigkeitswert an jedem einzelnen Punkt (12, 14, 16, 18, 20, 22) des Netzabschnittmodells (54) auf Grundlage der vorbestimmten thermischen Gleichgewichtsbeziehung (56), jeder Betriebsgrenztemperatur, jedes Leitungsparameters und von meteorologischen Parametern (58) zu berechnen,

**dadurch gekennzeichnet, dass** es weiter Mittel (46) zum Empfangen, durch den Rechner (48), von Windgeschwindigkeitswerten umfasst, die von einem Satz Windmessstationen gemessen werden, die um den Netzabschnitt herum stationiert sind, und dadurch, dass der Rechner (48) dafür programmiert ist:

- aus dem Satz Windmessstationen mindestens eine Windmessstation auszuwählen,
- zum Schätzen eines Windgeschwindigkeitswerts an jedem einzelnen Punkt auf Grundlage der empfangenen Windgeschwindigkeitswerte ein Windausbreitungsmodell (60) ab der mindestens einen ausgewählten Station zu den einzelnen Punkten (12, 14, 16, 18, 20, 22) des Netzabschnittmodells (54) anzuwenden, und
- die mindestens eine maximale Fähigkeit an jedem einzelnen Punkt unter Berücksichtigung des an jedem einzelnen Punkt geschätzten Windgeschwindigkeitswerts in der vorbestimmten thermischen Gleichgewichtsbeziehung (56) zu berechnen.

2. System (40) zur dynamischen Bestimmung von maximalen Stromtragfähigkeiten nach Anspruch 1, wobei der Rechner (48) genauer dafür programmiert (62) ist:

- auf Grundlage der empfangenen Windgeschwindigkeitswerte eine Hauptwindrichtung zu bestimmen, und
- die als Station im Wind bezeichnete Windmessstation auszuwählen, die in der bestimmten Hauptwindrichtung am weitesten stromaufwärts liegt.

3. System (40) zur dynamischen Bestimmung von maximalen Stromtragfähigkeiten nach Anspruch 1 oder 2, wobei:

- die vorbestimmte thermische Gleichgewichtsbeziehung (56) eine mathematische Gleichung ist, die mindestens mathematische Ausdrücke von Zugewinnen durch Joule-Effekt und Sonnenenergie mit mathematischen Ausdrücken von Verlusten durch Konvektion und elektromagnetische Strahlung in Gleichgewicht bringt, und
- der Rechner (48) dafür programmiert (66, 68) ist, den an jedem einzelnen Punkt geschätzten Windgeschwindigkeitswert im mathematischen Ausdruck des Konvektionsverlustes zu berücksichtigen.

4. System (40) zur dynamischen Bestimmung von maximalen Stromtragfähigkeiten nach einem der Ansprüche 1 bis 3, wobei der Rechner (48) weiter dafür programmiert (68) ist, einen Temperaturwert an mindestens einem Punkt des Netzabschnittmodells (54), für den ein Windgeschwindigkeitswert geschätzt wurde, auf Grundlage der vorbestimmten thermischen Gleichgewichtsbeziehung (56), einer Strommenge, die von der leitenden Leitung, welche diesen Punkt des Netzabschnittmodells (54) umfasst, getragen wird, von Leitungsparametern dieser leitenden Leitung und von meteorologischen Parametern (58) unter Berücksichtigung des geschätzten Windgeschwindigkeitswerts in der vorbestimmten thermischen Gleichgewichtsbeziehung (56) zu berechnen.

5. System (40) zur dynamischen Bestimmung von maximalen Stromtragfähigkeiten nach einem der Ansprüche 1 bis 4, wobei der Rechner (48) dafür programmiert ist, die Berechnung der mindestens einen maximalen Fähigkeit an jedem einzelnen Punkt unter der Bedingung auszulösen, dass vorbestimmte Kriterien von minimalem Windgeschwindigkeitswert und Kohärenz der empfangenen Windgeschwindigkeitswerte zueinander verifiziert sind.

6. System (40) zur dynamischen Bestimmung von maximalen Stromtragfähigkeiten nach Anspruch 5, wobei:

- das vorbestimmte Kriterium von minimalem Windgeschwindigkeitswert folgenderweise definiert ist: der Windgeschwindigkeitswert, der von der Station im Wind geliefert wird, muss in der Amplitude über einer ersten Schwelle liegen, und jeder Windgeschwindigkeitswert, der von einer anderen Windmessstation als der Station im Wind geliefert wird, muss in der Amplitude über einer zweiten Schwelle liegen, wobei die zweite Schwelle unter der ersten Schwelle liegt,
- das vorbestimmte Kriterium von Kohärenz der empfangenen Windgeschwindigkeitswerte zueinander folgenderweise ist: wenn die empfangenen Windgeschwindigkeitswerte Vektorwerte sind, muss der Winkelabstand zwischen den verschiedenen Richtungen dieser Vektorwerte unter einer dritten Schwelle bleiben, und muss der Abstand in der Amplitude zwischen den verschiedenen Normen dieser Vektorwerte unter einer vierten Schwelle bleiben.

7. Elektrische Übertragungseinrichtung mit dynamischer Bestimmung von maximalen Stromtragfähigkeiten, umfassend:

- einen Abschnitt (10) eines Hochspannungs-Stromübertragungsnetzes, der lokale Umspannwerke (12, 14, 16, 18) und mindestens eine Leitung zum Übertragen oder zum Verteilen von Hochspannungsstrom umfasst, die zwischen diesen lokalen Umspannwerken von Masten (20, 22) gehalten wird,
- einen Satz Windmessstationen (24, 26, 28, 30), die um den Netzabschnitt (10) herum stationiert sind, und
- ein System (40) zur dynamischen Bestimmung von maximalen Stromtragfähigkeiten nach einem der Ansprüche 1 bis 6.

8. Verfahren zur dynamischen Bestimmung von maximalen Stromtragfähigkeiten, die sich auf einen Abschnitt (10) eines Hochspannungs-Stromübertragungsnetzes beziehen, umfassend die folgenden Schritte:

- Erstellung (102) eines Modells (54) des Netzabschnitts (10), wobei dieses Modell (54) einzelne Punkte (12, 14, 16, 18, 20, 22) und mindestens eine Leitung (L1, L2, L3, L4, L5, L6, L7) umfasst, die zwischen diesen einzelnen Punkten Hochspannungsstrom leitet,
- Berechnung (114, 116, 118, 120, 122, 124, 126, 128, 130, 132) von mindestens einem maximalen Fähigkeitswert an jedem einzelnen Punkt (12, 14, 16, 18, 20, 22) des Netzabschnitt-(10) Modells (54) auf Grundlage einer vorbestimmten thermischen Gleichgewichtsbeziehung (56), einer Betriebsgrenztemperatur jeder leitenden Leitung (L1, L2, L3, L4, L5, L6, L7), von Leitungsparametern jeder leitenden Leitung (L1, L2, L3, L4, L5, L6, L7) und von meteorologischen Parametern (58),

**dadurch gekennzeichnet, dass** es weiter die folgenden Schritte umfasst:

- Messungen (106) von Windgeschwindigkeitswerten durch einen Satz Windmessstationen (24, 26, 28, 30), die um den Netzabschnitt (10) herum stationiert sind,
- Auswahl (108) von mindestens einer Windmessstation aus dem Satz Windmessstationen (24, 26, 28, 30),
- Anwendung (114) eines Windausbreitungsmodells (60) ab der mindestens einen ausgewählten Station zu den einzelnen Punkten (12, 14, 16, 18, 20, 22) des Netzabschnitt- (10) Modells (54) zum Schätzen eines Windgeschwindigkeitswerts an jedem einzelnen Punkt auf Grundlage der empfangenen Windgeschwindigkeitswerte, und
- Berechnung (114, 116, 118, 120, 122, 124, 126, 128, 130, 132) der mindestens einen maximalen Fähigkeit an jedem einzelnen Punkt unter Berücksichtigung des an jedem einzelnen Punkt geschätzten Windgeschwindigkeitswerts in der vorbestimmten thermischen Gleichgewichtsbeziehung (56) .

9. Verfahren zur dynamischen Bestimmung von maximalen Stromtragfähigkeiten nach Anspruch 8, wobei:

- jede leitende Leitung (L1, L2, L3, L4, L5, L6, L7) einer Standard-Stromtragfähigkeit unterliegt,
- die Berechnung (114, 116, 118, 120, 122, 124, 126, 128, 130, 132) der mindestens einen maximalen Fähigkeit an jedem einzelnen Punkt unter der Bedingung (110) ausgelöst (112) wird, dass vorbestimmte Kriterien von minimalem Windgeschwindigkeitswert und von Kohärenz der gemessenen Windgeschwindigkeitswerte zueinander verifiziert sind, und
- jede Standardfähigkeit durch die als optimale Fähigkeit bezeichnete kleinste der an den die Enden jeder jeweiligen leitenden Leitung bildenden einzelnen Punkten berechneten maximalen Fähigkeit ersetzt (128, 132) wird, wenn diese optimale Fähigkeit höher ist als die entsprechende Standardfähigkeit, und wenn die vorbestimmten Kriterien verifiziert sind.

10. Verfahren zur dynamischen Bestimmung von maximalen Stromtragfähigkeiten nach Anspruch 9, wobei:

- die Berechnung (114, 116, 118, 120, 122, 124, 126, 128, 130, 132) der mindestens einen maximalen Fähigkeit an jedem einzelnen Punkt zu einem Zeitpunkt T ausgelöst (112) und für einen Zeitpunkt T+H, wobei H>0, durch zeitliche Projektion (114) mithilfe des Windausbreitungsmodells (60) erstellt wird,
- zwischen den Zeitpunkten T und T+H die Berechnung (114, 116, 118, 120, 122, 124, 126, 128, 130, 132) der mindestens einen maximalen Fähigkeit für den Zeitpunkt T+H an jedem einzelnen Punkt wiederholt und durch zeitliche Projektion erstellt wird, und
- zum Zeitpunkt T+H der mindestens eine maximale Fähigkeitswert, der an jedem einzelnen Punkt zurückbehalten wird, der kleinste der entsprechenden, zwischen den Zeitpunkten T und T+H berechneten maximalen Fähigkeitswerte ist.

## Claims

1. A system (40) for dynamically determining maximum electric current carrying capacities relative to a portion (10) of a high-voltage electric current transmission network, comprising:

   - means (44) for storing a model (54) of the network portion, this model (54) comprising singular points (12, 14, 16, 18, 20, 22) and at least one high-voltage electric current-carrying line (L1, L2, L3, L4, L5, L6, L7) between these singular points, a predetermined thermal equilibrium relationship (56), an operating limit temperature of each current-carrying line and conduction parameters of each current-carrying line,
   - a computer (48), having access to the storing means (44), programmed (62, 64, 66, 68) to calculate at least one maximum capacity value at each singular point (12, 14, 16, 18, 20, 22) of the model (54) of the network portion on the basis of the predetermined thermal equilibrium relationship (56), of each operating limit temperature, of each conduction parameter and of weather parameters (58),

   **characterized in that** it further comprises means (46) for receiving, by the computer (48), wind speed values measured by a set of wind measurement stations deployed around the network portion, and **in that** the computer (48) is programmed to:

   - select at least one wind measurement station in the set of wind measurement stations,
   - apply a model (60) of wind propagation from said at least one selected station towards the singular points (12, 14, 16, 18, 20, 22) of the model (54) of the network portion, in order to estimate a wind speed value at each singular point on the basis of the wind speed values received, and
   - calculate said at least one maximum capacity at each singular point taking into account said wind speed value estimated at each singular point in the predetermined thermal equilibrium relationship (56).

2. The system (40) for dynamically determining maximum electric current carrying capacities as claimed in claim 1, wherein the computer (48) is more precisely programmed (62) to:

   - determine a main wind direction on the basis of the wind speed values received, and
   - select the wind measurement station, referred to as the leeward station, located the furthest upstream in the main wind direction determined.

3. The system (40) for dynamically determining maximum electric current carrying capacities as claimed in claim 1 or 2, wherein:

   - the predetermined thermal equilibrium relationship (56) is a mathematical equation that balances at least mathematical expressions of gains via the Joule effect and solar energy with mathematical expressions of losses via convection and electromagnetic radiation, and
   - the computer (48) is programmed (66, 68) to take into account said wind speed value estimated at each singular point in the mathematical expression of loss via convection.

4. The system (40) for dynamically determining maximum electric current carrying capacities as claimed in any of claims 1 to 3, wherein the computer (48) is further programmed (68) to calculate a temperature value in at least one point of the model (54) of the network portion for which a wind speed value has been estimated, on the basis of the predetermined thermal equilibrium relationship (56), a quantity of electric current carried by the current-carrying line comprising this point of the model (54) of the network portion, the conduction parameters of this current-carrying line and weather parameters (58), taking into account said estimated wind speed value in the predetermined thermal equilibrium relationship (56).

5. The system (40) for dynamically determining maximum electric current carrying capacities as claimed in any of claims 1 to 4, wherein the computer (48) is programmed to trigger the calculation of said at least one maximum capacity at each singular point with the conditions that predetermined criteria of a minimum value for the wind speed and coherency, between them, of the wind speed values received are upheld.

6. The system (40) for dynamically determining maximum electric current carrying capacities as claimed in claim 5, wherein:

   - the predetermined criterion for the minimum value of the wind speed is defined in the following way: the wind speed value supplied by the leeward station must be greater in amplitude than a first threshold and each wind speed value supplied by a wind measurement station other than the leeward station must be greater in amplitude than a second threshold, with the second threshold being less than the first threshold,
   - the predetermined criterion of coherency, between them, of the wind speed values received is defined in the following way: as the wind speed values received are vectorial, the angular difference between the various directions of these vector values must remain less than a third threshold and the difference in amplitude between the various norms of these vector values must remain less than a fourth threshold.

7.  An electric transmission installation with dynamic determination of maximum electric current carrying capacities, comprising:

    - a portion (10) of a high-voltage electric current transmission network comprising local electrical substations (12, 14, 16, 18) and at least one high-voltage electric current distribution or transmission line carried by pylons (20, 22) between these local electrical substations,
    - a set of wind measurement stations (24, 26, 28, 30) deployed around the network portion (10), and
    - a system (40) for dynamically determining maximum electric current carrying capacities as claimed in any of claims 1 to 6.

8.  A method for dynamically determining maximum electric current carrying capacities relative to a portion (10) of a high-voltage electric current transmission network, comprising the following steps:

    - establishing (102) a model (54) of the network portion (10), this model (54) comprising singular points (12, 14, 16, 18, 20, 22) and at least one high-voltage electric current-carrying line (L1, L2, L3, L4, L5, L6, L7) between these singular points,
    - calculating (114, 116, 118, 120, 122, 124, 126, 128, 130, 132) at least one maximum capacity value at each singular point (12, 14, 16, 18, 20, 22) of the model (54) of the network portion (10) on the basis of a predetermined thermal equilibrium relationship (56), an operating limit temperature of each current-carrying line (L1, L2, L3, L4, L5, L6, L7), conduction parameters of each current-carrying line (L1, L2, L3, L4, L5, L6, L7) and weather parameters (58),

    **characterized in that** it further comprises the following steps:

    - measuring (106) wind speed values by a set of wind measurement stations (24, 26, 28, 30) deployed around the network portion (10),
    - selecting (108) at least one wind measurement station in the set of wind measurement stations (24, 26, 28, 30),
    - applying (114) a model (60) of wind propagation from said at least one selected station towards the singular points (12, 14, 16, 18, 20, 22) of the model (54) of the network portion (10), in order to estimate a wind speed value at each singular point on the basis of the wind speed values received, and
    - calculating (114, 116, 118, 120, 122, 124, 126, 128, 130, 132) said at least one maximum capacity at each singular point taking into account said wind speed value estimated at each singular point in the predetermined thermal equilibrium relationship (56).

9.  The method for dynamically determining maximum electric current carrying capacities as claimed in claim 8, wherein:

    - each current-carrying line (L1, L2, L3, L4, L5, L6, L7) is subjected to an electric current carrying default capacity,
    - the calculating (114, 116, 118, 120, 122, 124, 126, 128, 130, 132) of said at least one maximum capacity at each singular point is triggered (112) with the condition (110) that predetermined criteria of a minimum value for the wind speed and coherency, between them, of the wind speed values measured are upheld, and
    - each default capacity is replaced (128, 132) with the smallest of the maximum capacities calculated at the singular points forming the ends of each respective current-carrying line, referred to as optimum capacity, if this optimum capacity is higher than the corresponding default capacity and if the predetermined criteria are upheld.

10.  The method for dynamically determining maximum electric current carrying capacities as claimed in claim 9, wherein:

    - the calculating (114, 116, 118, 120, 122, 124, 126, 128, 130, 132) of said at least one maximum capacity at each singular point is triggered (112) at an instant T and established by time projection (114) using the model (60) of wind propagation for an instant T+H where H>0,
    - between the instants T and T+H, the calculating (114, 116, 118, 120, 122, 124, 126, 128, 130, 132) of said at least one maximum capacity at each singular point is repeated and established by time projection for the instant T+H, and
    - at the instant T+H, said at least one maximum capacity value retained at each singular point is the smallest of the corresponding maximum capacity values calculated between the instants T and T+H.

## *Figure 1*

# Figure 2

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- US 5918288 A
- US 5559430 A
- WO 2007031435 A1
- WO 2014090416 A1
- US 2014180616 A

### Littérature non-brevet citée dans la description

- Dynamic line rating systems for transmission lines: topical report. U.S. Department of Energy, Avril 2014
- Guide for thermal rating calculations of overhead lines. B2-lignes aériennes, Décembre 2014
- **SCHELL et al.** Quantifying the limits of weather based dynamic line rating methods. *l'occasion de Cigré Canada, Conférence on Power Systems,* Septembre 2011
- IEEE standard for calculating the current-temperature relationship of bare overhead conductors. *IEEE Power Engineering Society sous la référence IEEE Std 738™-2006,* Janvier 2007
- Thermal behaviour of overhead conductors. *B2-lignes aériennes » de l'organisation Cigré, WG 22.12,* Août 2002